## Europäisches Patentamt
## European Patent Office
## Office européen des brevets

(11) Veröffentlichungsnummer: **0 182 982**
**A1**

(12) # EUROPÄISCHE PATENTANMELDUNG

(21) Anmeldenummer: 85110908.2

(22) Anmeldetag: 29.08.85

(51) Int. Cl.⁴: **H 03 B 5/32**
H 03 L 1/02, H 04 M 1/72

(30) Priorität: 12.11.84 DE 3441255

(43) Veröffentlichungstag der Anmeldung:
04.06.86 Patentblatt 86/23

(84) Benannte Vertragsstaaten:
AT CH,DE FR IT LI SE

(71) Anmelder: Hagenuk GmbH
Westring 431
2300 Kiel 1(DE)

(72) Erfinder: Hunecke, Ernst, Dipl.-Ing.
Bockelhornerweg 21
D-2355 Wankendorf(DE)

(74) Vertreter: Hansmann, Dierk, Dipl.-Ing.
Jessenstrasse 4
D-2000 Hamburg 50(DE)

(54) Oszillatorschaltung.

(57) Bei einer Oszillatorschaltung mit einem Schwingelement zur Frequenzbestimmung und einem Abstimmelement (1) zum Durchstimmen des Frequenzbereiches wird vorgeschlagen, daß ein SAW-Schwingelement mit akustischen Oberflächenwellen eingesetzt ist. Es ist dabei vorgesehen, daß über bestimmte Abstimmspannungen das Abstimmelement ansteuerbar ist, die ein Mikroprozessor (4) über einen Digital-Analog-Wandler (3) zuschaltet.

FIG. 1

## Oszillatorschaltung

Die Erfindung bezieht sich auf eine Oszillatorschaltung mit einem Schwingelement zur Frequenzbestimmung und einem Abstimmelement, wie eine Kapazitätsvariationsdiode, zum Durchstimmen des Frequenzbereiches.

Schaltungsanordnungen dieser Art sind in einer großen Vielfalt bekannt. Hierbei ist es auch bekannt, zur Erzeugung stabiler Frequenzen Synthesizer mit Phasenregelschaftungen (PLL) einzusetzen. Die dabei eingesetzten hochfrequenten Verteiler und die Phasenregelschaltungen benötigen jedoch viel Strom und zeigen häufig Nebenlinien auf den Referenzfrequenzen. Beim Einsatz von Quarzoszillatoren zur Erreichung der hohen Oszillatorfrequenzen werden in der Regel Vervielfacherstufen eingesetzt, die ebenfalls zusätzlichen Strom und beträchtlichen Filteraufwand zur Unterdrückung subharmonischer Frequenzen benötigen. Dieser Aufwand steht dem Einsatz derartiger Schaltungen beim mobilen Anlage, wie Funkanlagen bzw. schnurlosen Telefonen, entgegen.

Der Erfindung liegt daher die Aufgabe zugrunde, eine Schaltungsanordnung für Oszillatoren mit geringem Aufwand vorzusehen, um einen Einsatz in mobilen Empfangsgeräten, insbesondere in schnurlosen Telefonen, zu ermöglichen.

Diese Aufgabe ist gemäß der Erfindung dadurch gelöst, daß für das Schwingelement ein SAW-Schwingelement (surface acoustic wave) eingesetzt ist und daß die Kapazitätsvariationsdiode durch bestimmte Abstimmspannungen ansteuerbar ist, die ein Mikroprozessor über einen Digital-Analog-Wandler zuschaltet.

Durch die erfindungsgemäße Maßnahme ergibt sich eine erhebliche Verbesserung für Oszillatorschaltungen sehr hoher Frequenzen, insbesondere für Schaltungen bis 1 GHZ. Dies wird besonders durch den Einsatz des SAW-Schwingelemenes erzielt, wobei die notwendige Frequenzstabilität mit Hilfe der Mikroprozessorschleife gewährleistet wird. Aufwendige Phasenregelschaltungen sind daher nicht mehr erforderlich.

Weiterbildungen und vorteilhafte Ausgestaltungen der Erfindung sind durch die Merkmale der Unteransprüche gekennzeichnet. Hierbei werden auf einfache Weise über die Mikroprozessorschleife Temperatureinflüsse, Alterungen und Driften der Frequenz ausgeregelt.

Die Erfindung wird anhand der Zeichnung näher erläutert. Es zeigen:

Fig. 1    ein Blockschaltbild eines Oszillators mit Mikroprozessorschleife und Temperaturkompensation und

Fig. 2    ein Blockschaltbild nach Fig.1 ergänzt um eine Empfangsschaltung.

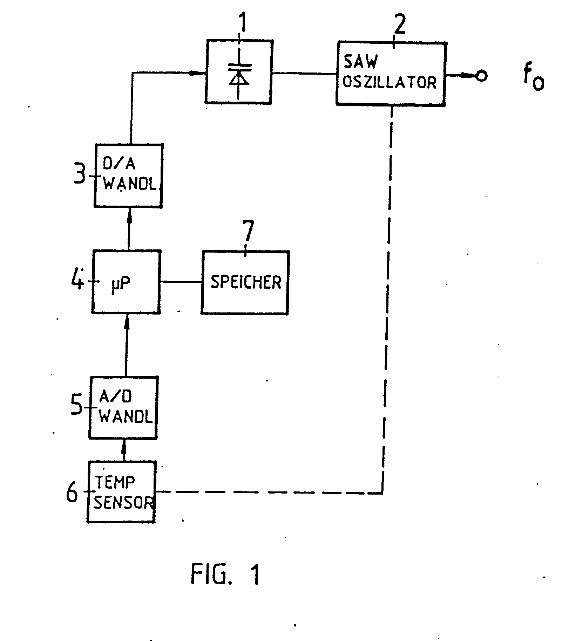

Das Blockschaltbild nach Fig. 1 zeigt einen Oszillator zur Erzeugung von Frequenzen im Bereich bis zu 1 GHZ. Als frequenzbestimmendes GLied ist ein SAW-Schwingelement 2 eingesetzt,

. . .

0182982

das in einer Regelschleife über einen Temperatur fühler 6, einen Analog-Digital-Wandler 5, einen Mikroprozessor 4, einen Digital-Analog-Wandler 3 und einer Kapazitätsvariationsdiode 1 liegt. Dem Mikroprozessor 4 ist dabei ein Speicher 7 zugeordnet. Der Mikroprozessor 4 bestimmt somit mit seinem digitalen Ausgangsbefehl die Frequenz des Oszillators.

Da die Kapazitätsvariationsdiode 1 eine analoge Ansteuerung verlangt, ist es notwendig, den Ausgangsbefehl des Mikroprozessors 4 zu wandeln. Diese Aufgabe übernimmt der Digital-Analog-Wandler 3. Im Speicher 7 können daher für bestimmte zu erzeugende Oszillatorfrequenzen Befehle abgespeichert werden, welchen bestimmte Kanäle innerhalb des Abstimmbereiches zugeordnet werden. Der Oszillator kann daher mit Hilfe der digitalen Steuerung jeweils exakt die Frequenz erzeugen, die einer bestimmten Kanalfrequenz zugeordnet ist. Die Umschaltung erfolgt durch entsprechende Ansteuerung der Kapazitätsvariationsdiode 1.

Der Einsatz des Mikroprozessors 4 ermöglicht gleichzeitig eine Temperaturkompensation beim SAW-Schwingelement 2 sowie das Ausregeln von Alterungen und das damit zusammenhängende Driften vorzunehmen. Temperaturschwankungen beim SAW-Schwingelement werden mit Hilfe des Temperaturfühlers 6 erfaßt, wobei das Temperatursignal nach Wandlung im Analog-Digital-Wandler 5 den Mikroprozessor 4 ansteuert. Dieser Mikroprozessor 4 regelt Temperaturschwankungen mit Hilfe der im Speicher 7 abgespeicherten Daten der Temperaturabhängigkeit durch entsprechende Ansteuerung

. . .

der Kapazitätsvariationsdiode 1 aus. Die im Mikroprozessor 4 eingesetzte Software-Routine erlaubt es, auftretenden Driften, z.B. aufgrund von Bauelementealterungen, entgegenzuwirken.

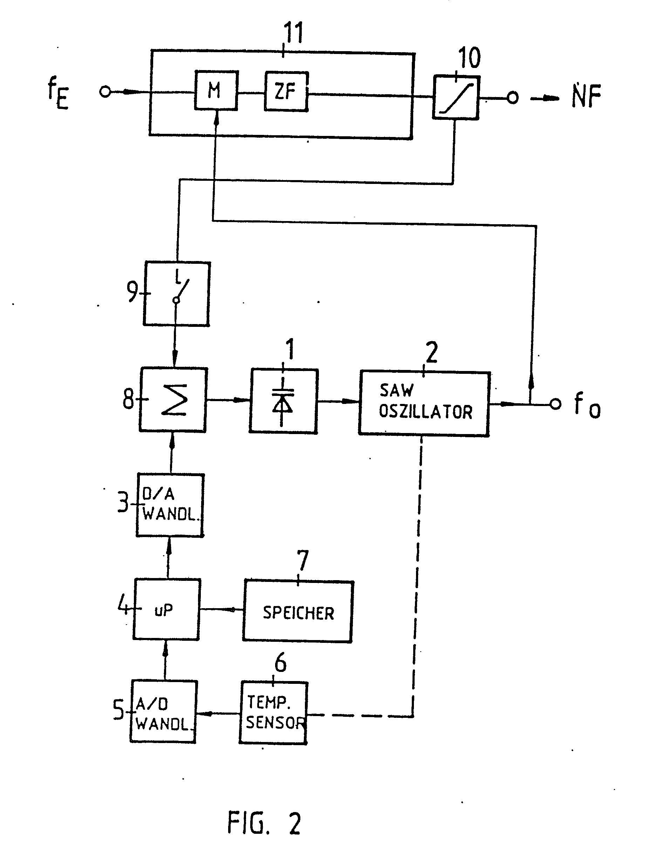

In der Darstellung nach Fig. 2 ist zusätzlich zum Oszillator eine Empfangsschaltung 11 zu sehen, bestehend aus einer Mischstufe M, einer Zwischenfrequenzschaltung ZF und einem Diskriminator 10. Die Empfangsschaltung 11 erhält vom Oszillator die Oszillatorfrequenz $f_o$, welche in der Mischstufe mit der Empfangsfrequenz gemischt wird. Die dabei entstehende Zwischenfrequenz wird über die Zwischenfrequenzschaltung ZF dem Diskriminator 10 zugeführt. Der Diskriminator erzeugt neben dem NF-Signal noch ein Regelsignal, das über einen Schalter 9 einer Summierstufe 8 zuschaltbar ist. An der Summierstufe 8 liegt gleichzeitig das gewandelte Ausgangssignal des Mikroprozessors 4 an, so daß die Kapazitätsdiode vom Summiersignal der Summierstufe 8 angesteuert wird. Hierdruch wird gleichzeitig eine automatische Frequenzregelung (AFC) für die Empfangsschaltung 11 erzielt.

- 5 -

0182982

· Patentansprüche

1. Oszillatorschaltung mit einem Schwingelement zur Frequenzbestimmung und einem Abstimmelement, wie eine Kapazitätsvariationsdiode, zum Durchstimmen des Frequenzbereiches, dadurch gekennzeichnet, daß für das Schwingelement ein SAW-Schwingelement (2) (surface acoustic wave) eingesetzt ist und daß die Kapazitätsvaiationsdiode (1) durch bestimmte Abstimmspannungen ansteuerbar ist, die ein Mikroprozessor (4) über einen Digital-Analog-Wandler (3) zuschaltet.

2. Oszillatorschaltung nach Anspruch 1, dadurch gekennzeichnet, daß in einem Speicher (7) des Mikroprozessors (4) Schaltbefehle speicherbar sind, welche bestimmten, innerhalb des Durchstimmbereiches liegenden Kanalfrequenzen zugeordnet sind.

3. Oszillatorschaftung nach Anspruch 1 oder 2, dadurch gekennzeichnet, daß dem SAW-Schwingelement (2) ein Temperaturfühler (6) zugeordnet ist, dessen Ausgangssignal zur Temperaturkompensation über einen Analog-Digital-Wandler (5) den Mikroprozessor (4) ansteuert und daß im Speicher (7) des Mikroprozessors (4) die Daten der Temperaturabhängigkeit vom SAW-Schwingelement (2) abgespeichert sind.

4. Oszillatorschaltung nach einem der Ansprüche 1 bis 3, dadurch gekennzeichnet, daß zur Vergrößerung des Abstimmbereiches mehrere SAW-Schwingelemente (2) entsprechend zusammenschaltbar sind.

5. Oszillatorschaltung nach einem der Ansprüche 1 bis 4, dadurch gekennzeichnet, daß das Ausgangssignal des Oszillators (2) der Mischstufe (M) einer Empfangsschaltung (11) zugeleitet ist, die über eine Zwischenfrequenzschaltung (ZF) und eine Diskriminatorschaltung (10) ein NF-Ausgangssignal erzeugt und daß die Diskriminatorschaltung (10) ihr Regelsignal über einen Schalter (9) und eine gleichzeitig vom Ausgangssignal des Digital-Analog-Wandlers (3) angesteuerte Summierstufe (8) der Kapazitätsvariationsdiode (1) zuleitet.

6. Oszillatorschaltung nach einem der vorhergehenden Ansprüche, dadurch gekennzeichnet, daß im Speicher (7) des Mikroprozessors (4) eine Software-Routine eingesetzt ist, welche bei Alterungen der Bauelemente bzw. Drift des Oszillators (2) eine Korrektur, insbesondere der Frequenzzuordnungen erlaubt.

FIG. 1

FIG. 2

Europäisches
Patentamt

EUROPÄISCHER RECHERCHENBERICHT

0182982
Nummer der Anmeldung

EP 85 11 0908

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| Y | DE-A-3 014 093  (F. WEINZIERL) * Figur 1, Anspruch 3 * | 1 | H 03 B  5/32 H 03 L  1/02 H 04 M  1/72 |
| A | * Figur 1, Anspruch 1, Seite 9, Zeilen 20-27 * | 2,3,6 | |
| | --- | | |
| Y | US-A-3 990 021  (C.S. HARTMANN et al.) * Figur 5; Spalte 8, Zeile 24 - Spalte 9, Zeile 12 * | 1 | |
| | --- | | |
| A | IEEE TRANSACTIONS ON MICROWAVE THEORY AND TECHNIQUES, Band MTT 29, Dezember 1981, Seiten 1327-1333, New York, US; B.Y. LAO et al.: "SAW Oscillators in UHF Transit Satellite Links" * Seite 1330, Figur 5 * | 5 | |
| | --- | | RECHERCHIERTE SACHGEBIETE (Int. Cl.4) |
| A | IEEE TRANSACTIONS ON SONICS AND ULTRASONICS SU 31, Januar 1984, Seiten 40-45, New York, US; C.K. CAMPBELL et al.: "Study of a UHF Mobile Radio Receiver Using a Voltage-Controlled SAW Local Oscillator" * Seite 41, Figur 1; Seite 40, Spalte 2, Zeile 30 - Seite 41, Spalte 1, Zeile 30 * | 5 | H 03 B  5/18 H 03 B  5/32 H 03 L  1/02 H 04 M  1/72 |
| | ---          -/- | | |

Der vorliegende Recherchenbericht wurde für alle Patentansprüche erstellt.

| Recherchenort BERLIN | Abschlußdatum der Recherche 17-02-1986 | Prüfer BREUSING J |
|---|---|---|

Europäisches
Patentamt

EUROPÄISCHER RECHERCHENBERICHT

0182982

EP 85 11 0908

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int Cl.4) |
|---|---|---|---|
| A | PATENT ABSTRACTS OF JAPAN, Band 8, Nr. 119 (E-248)[1556], 5. Juni 1984; & JP - A - 59 33906 (NIPPON DENKI K.K.) 24.02.1984 --- | | |
| A | US-A-3 855 548 (A.K. NANDI et al.) * Figur 1, Zusammenfassung * ----- | | |

RECHERCHIERTE
SACHGEBIETE (Int. Cl.4)

Der vorliegende Recherchenbericht wurde für alle Patentansprüche erstellt.

| Recherchenort | Abschlußdatum der Recherche | Prüfer |
|---|---|---|
| BERLIN | 17-02-1986 | BREUSING J |